# EUROPEAN PATENT APPLICATION

(11) **EP 4 808 301 A1**
(43) Date of publication of application: **16.09.2026**
(21) Application number: 25899451.6
(22) Date of filing: 11.12.2025
(51) Int. Cl.: H05K 7/20

(54) **COMBINED AIR-CONDITIONING UNIT AND CONTROL METHOD**

(30) Priority: 18.12.2024 CN 202411878496
(71) Applicant: Guangdong Envicool Technology Co., Ltd., Sanjiao Town, Zhongshan Guangdong 528400 (CN)
(72) Inventor: ZHU, Xin, Zhongshan, Guangdong 528400 (CN); ZHAO, Peng, Zhongshan, Guangdong 528400 (CN)
(74) Representative: Torggler & Hofmann Patentanwälte - Innsbruck
(86) International application number: PCT/CN2025/141745
(87) International publication number: WO 2026/130206

(57) **Abstract**

A composite air-conditioning unit and a control method therefor are provided, relating to the technical field of air conditioning for equipment rooms. The composite air-conditioning unit includes an outdoor heat exchange system and an indoor heat exchange system. The outdoor heat exchange system includes a main loop, a first condenser, and a pressure pump, with the main loop provided with several branches corresponding to the indoor heat exchange system. The indoor heat exchange system includes a compressor, a second condenser, a throttling element, and a second evaporator. Each indoor heat exchange system corresponds to at least two branches. One of the at least two branches is provided with a first electronic control valve and a first evaporator connected in series, while another of the at least two branches is provided with a second electronic control valve and exchanges heat with the second condenser to remove heat from a refrigerant in the indoor heat exchange system. Both the first evaporator and the second evaporator are located indoors, with at least one of them providing cooling capacity to the indoor space, and they are arranged in series in an airflow direction. In the present application, the unit can operate in different cooling modes based on various outdoor conditions, maximizing the utilization of outdoor natural cooling source.

## Description

The present application claims priority to Chinese Patent Application No. 202411878496.2, titled "COMPOSITE AIR-CONDITIONING UNIT AND CONTROL METHOD THEREFOR", filed on December 18, 2024 with the China National Intellectual Property Administration, which is incorporated herein by reference in its entirety.

### FIELD

The present application relates to the technical field of air conditioning in equipment rooms, and in particular to a composite air-conditioning unit and a control method therefor.

### BACKGROUND

Currently, most large-scale data center equipment rooms employ indirect evaporative cooling units, fluorine pump multi-split units, or the like. Conventional room-level and in-row air conditioners, due to their low energy efficiency ratios, are predominantly used in small equipment rooms, power distribution rooms, and battery rooms.

In the process of implementing the present application, it is found that at least the following issues exist in the related art.

The existing air-conditioning units fail to automatically adjust their operating modes based on different outdoor operating conditions, which prevents the air-conditioning units from fully utilizing outdoor natural cooling sources. Consequently, the cooling energy efficiency of the air-conditioning units is low, causing the increase of the power consumption in the data centers.

Therefore, in view of the aforementioned technical issues, how to maximize the utilization of outdoor natural cooling sources while ensuring the cooling energy efficiency of the air-conditioning units is a technical issue that needs to be addressed by those skilled in the art.

### SUMMARY

An object of the present application is to provide a composite air-conditioning unit and a control method for the composite air-conditioning unit, which can operate in different cooling modes based on various outdoor operating conditions to maximize the utilization of outdoor natural cooling sources.

To achieve the aforementioned object, a composite air-conditioning unit is provided according to the present application, including an outdoor heat exchange system and an indoor heat exchange system. The outdoor heat exchange system includes a main loop for a refrigerant to flow through. A first condenser and a pressure pump are provided on the main loop. The first condenser is configured to exchange heat with an external environment. Multiple branches corresponding to the indoor heat exchange system are provided on the main loop.

The indoor heat exchange system includes a compressor, a second condenser, a throttling element, and a second evaporator, which are connected to form a refrigerant circulation loop of the indoor heat exchange system. A number of the indoor heat exchange system is at least one. Each indoor heat exchange system corresponds to at least two branches of the multiple branches. One of the at least two branches is provided with a first electronic control valve and a first evaporator that are connected in series. Another of the at least two branches is provided with a second electronic control valve and is configured to exchange heat with the second condenser to remove heat from a refrigerant in the indoor heat exchange system.

Both the first evaporator and the second evaporator are located in an indoor space. At least one of the first evaporator and the second evaporator is configured to provide cooling capacity to the indoor space. Moreover, the first evaporator and the second evaporator are arranged in series in an airflow direction.

Preferably, the first condenser is an evaporative condenser, which includes a heat exchange coil in communication with the main loop. An external fan is provided at a side of the heat exchange coil. The evaporative condenser further includes a spray device configured to spray towards the heat exchange coil. A temperature sensor and/or a pressure sensor is provided at an outlet end of the heat exchange coil to detect a refrigerant temperature and/or a refrigerant pressure at an outlet of the evaporative condenser.

Preferably, the refrigerant in the outdoor heat exchange system and the refrigerant in the indoor heat exchange system are fluorinated refrigerants.

Preferably, the outdoor heat exchange system further includes a liquid storage tank provided on the main loop. A number of the pressure pump is at least two, and the at least two pressure pumps are connected in parallel and arranged at a liquid outlet end of the liquid storage tank.

A control method, applied to the aforementioned composite air-conditioning unit, includes:
obtaining a first switching pressure and a second switching pressure that are predetermined, and obtaining a refrigerant pressure at an outlet of the first condenser under a current outdoor temperature, where the second switching pressure is higher than the first switching pressure;
in a case that the refrigerant pressure is lower than the first switching pressure, shutting down the indoor heat exchange system, opening the first electronic control valve, and closing the second electronic control valve;
in a case that the refrigerant pressure is higher than or equal to the first switching pressure and lower than or equal to the second switching pressure, obtaining a unit load rate in the indoor space and a target load rate that is predetermined, where in a case that the unit load rate is higher than the target load rate, activating the indoor heat exchange system, and opening the first electronic control valve and the second electronic control valve; in a case that the unit load rate is lower than or equal to the target load rate, shutting down the indoor heat exchange system, opening the first electronic control valve, and closing the second electronic control valve; and
in a case that the refrigerant pressure is higher than the second switching pressure, activating the indoor heat exchange system, closing the first electronic control valve, and opening the second electronic control valve.

Preferably, the step of activating the indoor heat exchange system and opening the first electronic control valve and the second electronic control valve includes:
maintaining the first electronic control valve at a maximum opening degree, performing PID regulation on the second electronic control valve based on a pressure of the second condenser of the indoor heat exchange system, performing PID calculation for the compressor of the indoor heat exchange system based on a predetermined indoor temperature and an actual indoor temperature, and regulating an operating frequency of the compressor based on PID values.

Preferably, the step of activating the indoor heat exchange system, closing the first electronic control valve, and opening the second electronic control valve includes:
performing PID regulation on the second electronic control valve based on a pressure of the second condenser of the indoor heat exchange system, performing PID calculation for the compressor of the indoor heat exchange system based on a predetermined indoor temperature and an actual indoor temperature, and regulating the operating frequency of the compressor based on PID values.

Preferably, after the step of activating the indoor heat exchange system, closing the first electronic control valve, and opening the second electronic control valve, the control method includes:
obtaining the unit load rate in the indoor space and the target load rate that is predetermined, where in response to the unit load rate being lower than or equal to the target load rate, shutting down the indoor heat exchange system, opening the first electronic control valve, and closing the second electronic control valve.

Preferably, the step of shutting down the indoor heat exchange system and opening the first electronic control valve includes:
performing PID calculation based on the predetermined indoor temperature and the actual indoor temperature, and regulating an opening degree of the first electronic control valve based on PID values.

Preferably, obtaining a third switching pressure that is predetermined, and determining whether the refrigerant pressure is lower than the third switching pressure, where the third switching pressure is lower than the second switching pressure, where in a case that the refrigerant pressure is lower than the third switching pressure, activating only an external fan corresponding to the first condenser; and in a case that the refrigerant pressure is higher than or equal to the third switching pressure, activating both the external fan and a spray device.

Preferably, PID regulation is performed on a rotational speed of the external fan or a spray water volume of the spray device based on the refrigerant pressure.

Compared to the related art, the technical solutions provided in the present application offers at least the following beneficial effects.

The composite air-conditioning unit in the present application includes an outdoor heat exchange system and an indoor heat exchange system. Based on the refrigerant pressure at the outlet of the first condenser of the outdoor heat exchange system, the indoor heat exchange system is controlled to be activated or shut down, and the first and second electronic control valves are controlled to open or close, enabling the air-conditioning unit to operate in different cooling modes. The refrigerant pressure reflects the outdoor temperature, with higher outdoor temperature resulting in higher refrigerant pressure. This allows the air-conditioning unit to adjust its cooling mode based on various outdoor operating conditions and fully utilize outdoor natural cooling source in each cooling mode, enabling the first condenser of the outdoor heat exchange system to fully exchange heat with the outdoor natural cooling source. This further allows the refrigerant in the outdoor heat exchange system to provide cooling source for indoor equipment rooms or the indoor heat exchange system to maximize the utilization of the outdoor natural cooling source.

Furthermore, in different cooling modes of the air-conditioning unit, at least one of the first and second evaporators provides cooling capacity to the indoor space. PID regulation can be performed on the opening degree of the first electronic control valve or the operating frequency of the compressor of the indoor heat exchange system based on the predetermined and actual indoor temperatures. PID regulation can also be performed on the opening degree of the second electronic control valve based on the condensation pressure of the indoor heat exchange system. This ensures precise control of the air outlet temperature of the air-conditioning unit at the indoor side, thus guaranteeing its cooling energy efficiency.

### BRIEF DESCRIPTION OF THE DRAWINGS

In order to describe the technical solutions in the embodiments of the present application or in the related art more clearly, the drawings for describing the embodiments or the related art are briefly introduced hereinafter. Apparently, the drawings in the following description show merely the embodiments of the present application, and those skilled in the art can obtain other drawings based on these drawings without creative efforts.
FIG. 1 is a schematic view illustrating a principle of a composite air-conditioning unit according to an embodiment of the present application;
FIG. 2 shows a refrigerant flow direction in a composite air-conditioning unit according to an embodiment of the present application when operating in a heat pipe mode;
FIG. 3 shows a refrigerant flow direction in a composite air-conditioning unit according to an embodiment of the present application when operating in a pre-cooling mode; and
FIG. 4 shows a refrigerant flow direction in a composite air-conditioning unit according to an embodiment of the present application when operating in a compressor mode.

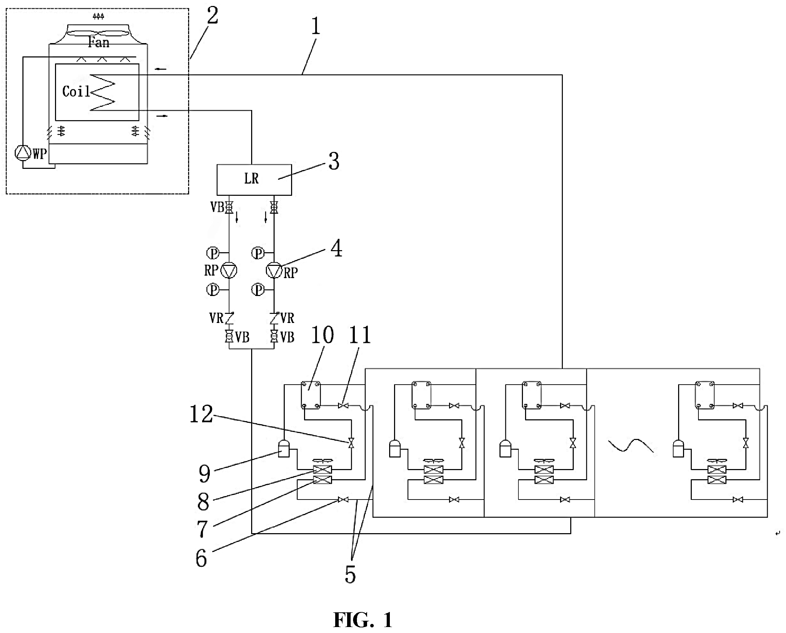

Reference numerals in FIGS. 1 to 4 are as follows:

| | | | |
|---|---|---|---|
| 1 | main loop; | 2 | first condenser; |
| 3 | liquid storage tank; | 4 | pressure pump; |
| 5 | branch; | 6 | first electronic control valve; |
| 7 | first evaporator; | 8 | second evaporator; |
| 9 | compressor; | 10 | second condenser; |
| 11 | second electronic control valve; | 12 | throttling element. |

### DETAILED DESCRIPTION OF THE EMBODIMENTS

Hereinafter technical solutions in embodiments of the present application are described clearly and completely with reference to the drawings in the embodiments of the present application. Apparently, the described embodiments are only some rather than all embodiments of the present application. Based on the embodiments of the present application, all other embodiments obtained by those skilled in the art without any creative work shall fall within the protection scope of the present application.

It should be noted that in the present embodiment, orientations or positional relationships indicated by terms such as "upper", "lower", "front", "rear" and the like, are based on the orientations or the positional relationships as shown in the drawings. These terms are only intended for facilitating and simplifying description of the present application, and do not explicitly or implicitly indicate that the device or element referred to must have a specific orientation or must be constructed and operated in a specific orientation. Therefore, the terms shall not be construed as limitations on the present application. In addition, terms such as "first", "second", "third", "fourth" and the like are merely for description, and should not be construed as indicating or implying relative importance.

In order to enable those skilled in the art to better understand the solutions of the present application, the present application is further described in detail hereinafter with reference to the drawings and the embodiments.

Referring to FIG. 1, in this embodiment, a composite air-conditioning unit is provided, including an outdoor heat exchange system and an indoor heat exchange system. The indoor heat exchange system may be disposed in those areas inside an equipment room where heat is generated. Depending on the actual cooling requirements and the number of heat-generating areas, multiple indoor heat exchange systems may be provided to perform precise cooling of these heat-generating areas.

The outdoor heat exchange system includes a main loop 1, which is partially located outdoors. The main loop 1 allows a refrigerant to circulate therein. A first condenser 2 is provided on the main loop 1, allowing heat exchange between the refrigerant and an external environment. That is, when the refrigerant in the main loop 1 passes through the first condenser 2, it exchanges heat with an outdoor natural cooling source through the first condenser 2, thereby discharging the heat of the refrigerant to the outdoor environment while reducing a temperature of the refrigerant.

Moreover, multiple branches 5 corresponding to the indoor heat exchange system are provided on the main loop 1. Since the indoor heat exchange system is arranged inside the equipment room, the corresponding branches 5 should also be arranged inside the equipment room. It should be noted that as a branch 5 of the main loop 1, each branch 5 is connected in series with the main loop 1 through both ends of the branch 5. Therefore, when the branch 5 is in communication with the main loop 1, the refrigerant in the main loop 1 can enter the branch 5 and return to the main loop 1, enabling the circulation of the refrigerant in the outdoor heat exchange system. The indoor heat exchange system includes a second condenser 10. Each indoor heat exchange system corresponds to at least two branches 5. Referring to FIG. 1, one of the at least two branches 5 is provided with a first electronic control valve 6 and a first evaporator 7 connected in series, and another of the at least two branches 5 is provided with a second electronic control valve 11. The refrigerant in the branch 5 provided with the second electronic control valve 11 can exchange heat with the second condenser 10, thereby removing the heat released by the second condenser 10. This reduces the condensation pressure (temperature) of the second condenser 10, ensuring the cooling efficiency of the indoor heat exchange system.

It should be noted that the first electronic control valve 6 and the second electronic control valve 11 are primarily used to control communication and isolation of the corresponding branches 5. Furthermore, by regulating opening degrees of the first electronic control valve 6 and the second electronic control valve 11, flow rates of the refrigerant in the respective branches 5 may be regulated. Therefore, the first electronic control valve 6 and the second electronic control valve 11 may be electronic expansion valves, solenoid valves, electric ball valves, or the like. In other words, both the first electronic control valve 6 and the second electronic control valve 11 are electronic control valves with adjustable opening degrees, enabling precise control of the refrigerant flow rates in the respective branches 5.

In some embodiments, the indoor heat exchange system further includes a compressor 9, a second evaporator 8, and a throttling element 12. Referring to FIGS. 1 to 4, the compressor 9, the second condenser 10, the second evaporator 8, and the throttling element 12 are connected to form a refrigerant circulation loop of the indoor heat exchange system. The throttling element 12 may be an electronic expansion valve. When the indoor heat exchange system is in operation (in a compressor mode), the second evaporator 8 is configured to supply air to the equipment room, thereby reducing the temperature inside the equipment room. It should be noted that the indoor heat exchange system and the outdoor heat exchange system are two independent systems. The refrigerant within each of the two systems only circulates within its respective heat exchange system, and there is no cross-flow between the two systems. Under certain operating conditions, however, the refrigerant in the outdoor heat exchange system and the refrigerant in the indoor heat exchange system can exchange heat with each other in the second condenser 10, thereby removing the heat from the refrigerant in the second condenser 10.

In some embodiments, both the first evaporator 7 and the second evaporator 8 are located indoors, that is, inside the equipment room. This ensures that at least one of the first evaporator 7 and the second evaporator 8 provides cooling capacity to an indoor space when the air-conditioning unit operates in different cooling modes.

Further, the first evaporator 7 and the second evaporator 8 may be arranged adjacent to each other, that is, the first evaporator 7 and the second evaporator 8 are located close to each other, and the first evaporator 7 and the second evaporator 8 are connected in series in an airflow direction. This requires only a single fan to supply the cooling capacity generated by the first evaporator 7 and/or the second evaporator 8 into the indoor space.

It should be noted that there may be multiple indoor heat exchange systems and they are independent of each other. Therefore, the indoor heat exchange systems may be controlled independently based on their different positions or the actual cooling requirements in the equipment room. This avoids situations where the multiple indoor heat exchange systems operate synchronously, and result in either excessive or insufficient cooling capacity.

Referring to FIG. 1, the first condenser 2 in the present application is an evaporative condenser. The heat exchange efficiency of an evaporative condenser is higher than that of a dry cooler and a closed-circuit cooling tower. Direct heat transfer can be performed between the evaporative condenser and the main loop 1, further improving heat exchange efficiency. In cold regions during winter, there is no need to add antifreeze, and there is no concern about coil freezing or cracking.

The evaporative condenser generally includes a heat exchange coil in communication with the main loop 1. The refrigerant in the main loop 1 can enter the heat exchange coil. An external fan is provided at a side of the heat exchange coil. The rotation of the external fan can increase the air flow rate around the heat exchange coil, thereby improving the heat exchange efficiency between the refrigerant in the heat exchange coil and the external environment. Moreover, the evaporative condenser further includes a spray device that is configured to spray water onto the heat exchange coil. The spray device may continuously spray water onto the heat exchange coil through a circulation pump, further enhancing the heat exchange effect of the heat exchange coil based on the effect of the external fan. Additionally, a temperature sensor and/or a pressure sensor is provided at an outlet end of the heat exchange coil to detect a refrigerant temperature and/or a refrigerant pressure at an outlet of the evaporative condenser. The refrigerant temperature or the refrigerant pressure at the outlet of the evaporative condenser represents the outdoor temperature conditions. In other words, the higher the outdoor temperature, the higher the refrigerant temperature or the refrigerant pressure at the outlet, and vice versa.

In some embodiments, the first condenser 2 may alternatively configured as one or more finned-tube condensers, which will not be described in detail herein, and as long as the heat exchange between the refrigerant in the main loop 1 and the external natural cooling source can be achieved, all of above fall within the scope of protection of the present application.

The outdoor heat exchange system of the present application further includes a pump cabinet arranged on the main loop 1. The pump cabinet is used for refrigerant condensation and transmission. Specifically, the pump cabinet includes a liquid storage tank 3 and a pressure pump 4. The pressure pump 4 is configured to provide a driving force for the refrigerant to flow through the main loop 1 and the branches 5. The liquid storage tank 3 is used to store the refrigerant to ensure that there is sufficient refrigerant circulating in the main loop 1. When the liquid storage tank 3 is connected upstream of the pressure pump 4, it can also protect the pressure pump 4. To ensure the driving force for the refrigerant circulation in the main loop 1, at least two pressure pumps 4 may be provided, which are connected in parallel and arranged at a liquid outlet end of the liquid storage tank 3. Additionally, control valves, pressure and temperature sensors, check valves, or the like, may be provided as needed to meet the refrigerant flow requirements.

Considering that the indoor heat exchange system is arranged inside the equipment room, it should have a certain level of compactness to avoid occupying additional indoor space. Therefore, in this embodiment, the second condenser 10 may be configured as a plate heat exchanger for heat exchange between fluorinated refrigerants. Accordingly, the refrigerants in the outdoor and indoor heat exchange systems are fluorinated refrigerants. The plate heat exchanger for heat exchange between fluorinated refrigerants replaces the conventional plate heat exchanger for heat exchange between water and fluorinated refrigerant, which on the one hand enables efficient heat exchange with the refrigerant in the outdoor heat exchange system, and on the other hand effectively avoids scaling issues of the heat exchanger and potential water leakage risks inside the equipment room. Additionally, using fluorinated refrigerant instead of water eliminates the risk of coil freezing and rupture during cold seasons. Alternatively, the second condenser 10 at the indoor side may be other types of heat exchangers, such as shell-and-tube heat exchangers, with different physical dimensions and heat exchange efficiencies.

A control method applicable to the aforementioned composite air-conditioning unit is further provided according to the present application. A case where one indoor heat exchange system is provided is taken as an example for introduction in the present application. In a case that there are multiple indoor heat exchange systems, since they are independent of each other, the control methods for the other indoor heat exchange systems may be referred to the control method for the one indoor heat exchange system and will not be described in detail herein. The control method includes following steps.

A first switching pressure and a second switching pressure, which are predetermined, are obtained. The second switching pressure is higher than the first switching pressure. A refrigerant pressure at the outlet of the first condenser 2 under a current outdoor temperature is obtained. The first switching pressure and the second switching pressure are manually predetermined pressure values, where the switching pressures meeting the requirements may be obtained through multiple experiments based on the actual conditions of the equipment room. Alternatively, switching temperatures may be used instead of the switching pressures, in which case a refrigerant temperature at the outlet of the first condenser 2 under the current outdoor temperature is obtained, as long as their units for comparison are consistent. Both the refrigerant temperature and the refrigerant pressure can represent the outdoor temperature conditions, that is, the higher the outdoor temperature, the higher the refrigerant temperature or the refrigerant pressure, and vice versa.

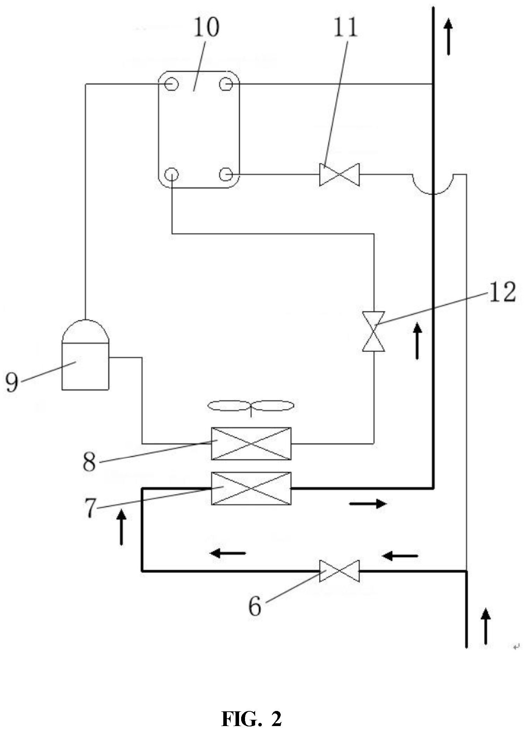

Based on the above, in a case that the refrigerant pressure at the outlet of the first condenser 2 is lower than the first switching pressure, the indoor heat exchange system is shut down (the compressor 9 is shut down), the first electronic control valve 6 is opened, and the second electronic control valve 11 is closed. This indicates that the outdoor temperature is low, and the first condenser 2 has good heat exchange efficiency. The refrigerant pressure at the outlet of the first condenser 2 is low, and heat exchange between the first condenser 2 and the outdoor natural cooling source is sufficient to meet the cooling demand of the equipment room. In this case, the air-conditioning unit operates in a heat pipe mode. Referring to FIG. 2, the refrigerant in the outdoor heat exchange system absorbs heat through the first evaporator 7, and the cooling capacity generated by the first evaporator 7 is discharged to the indoor space to meet the indoor cooling demand. In a case that the refrigerant pressure at the outlet of the first condenser 2 is higher than or equal to the first switching pressure, the next step is performed. It should be noted that the heat pipe mode refers to a mode in which the refrigerant circulates and performs heat exchange in the outdoor heat exchange system without providing a compressor in the outdoor heat exchange system.

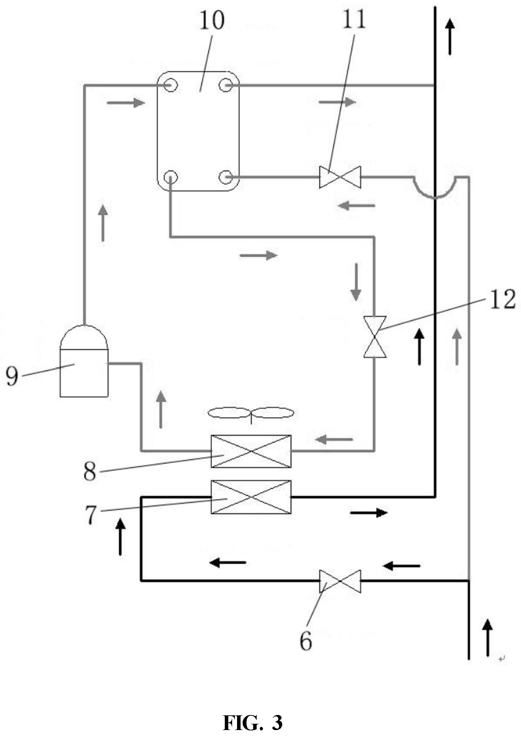

In a case that the refrigerant pressure at the outlet of the first condenser 2 is higher than or equal to the first switching pressure and lower than or equal to the second switching pressure, the air-conditioning unit operates in a hybrid mode. Meanwhile, a unit load rate in the indoor space and a target load rate that is predetermined are obtained. This indicates that the outdoor temperature is higher than in the heat pipe mode, resulting in an increase in the refrigerant pressure at the outlet of the first condenser 2 and a decrease in heat exchange efficiency of the first condenser 2. Therefore, the unit load rate in the indoor space and the predetermined target load rate need to be obtained. The unit load rate actually represents the indoor cooling demand. The target load rate should be obtained through multiple experiments based on unit load rate. In a case that the unit load rate is higher than the target load rate, it indicates a relatively high indoor cooling demand. In this case, the indoor heat exchange system is activated, and both the first electronic control valve 6 and the second electronic control valve 11 are opened. Referring to FIG. 3, the air-conditioning unit operates in a pre-cooling mode. One part of the refrigerant in the outdoor heat exchange system exchanges heat with the second condenser 10, and the other part cooperates with the first evaporator 7, allowing the first evaporator 7 to provide cooling capacity to the equipment room. It can be seen that in this pre-cooling mode, both the second evaporator 8 and the first evaporator 7 of the indoor heat exchange system can provide cooling capacity to the equipment room. Meanwhile, the refrigerant in the outdoor heat exchange system can also exchange heat with the second condenser 10 to reduce a condensation pressure of the second condenser 10.

In a case that the unit load rate is lower than or equal to the target load rate, it indicates a relatively low indoor cooling demand. In this case, the indoor heat exchange system is shut down, the first electronic control valve 6 is opened, and the second electronic control valve 11 is closed. The air-conditioning unit also operates in the aforementioned heat pipe mode.

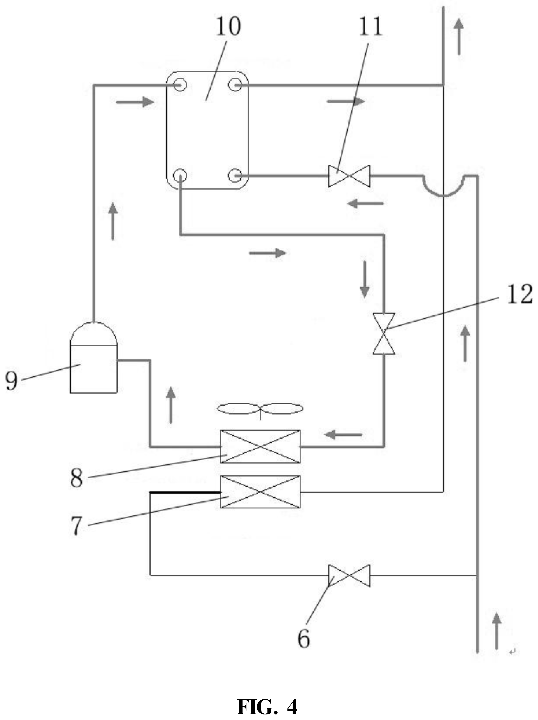

In a case that the refrigerant pressure at the outlet of the first condenser 2 is higher than the second switching pressure, it indicates a further increase in the outdoor temperature and a further decrease in the heat exchange efficiency of the first condenser 2. In this case, the unit operates in a compressor mode. Referring to FIG. 4, the indoor heat exchange system is activated, the first electronic control valve 6 is closed, and the second electronic control valve 11 is opened. In this case, the refrigerant in the outdoor heat exchange system is only used for heat exchange with the second condenser 10 of the indoor heat exchange system to further reduce the condensation pressure of the second condenser 10. In this mode, the indoor heat exchange system alone provides cooling capacity to the equipment room, and the heat exchange efficiency of the indoor heat exchange system is ensured based on the heat exchange between the refrigerant in the outdoor heat exchange system and the second condenser 10, thereby fully utilizing the outdoor natural cooling source for indoor cooling and temperature reduction.

It should be noted that in the control method according to the present application, the control may be achieved by specific steps, as follows.

After the step of obtaining the first switching pressure and the second switching pressure that are predetermined, and the refrigerant pressure at the outlet of the first condenser 2, it is first determined whether the refrigerant pressure is lower than the first switching pressure. In a case that the refrigerant pressure is lower than the first switching pressure, the indoor heat exchange system is shut down, the first electronic control valve 6 is opened, and the second electronic control valve 11 is closed. In a case that the refrigerant pressure is higher than or equal to the first switching pressure, the next step is performed.

It is determined whether the refrigerant pressure is lower than or equal to the second switching pressure. In a case that the refrigerant pressure is lower than or equal to the second switching pressure, a unit load pressure in the indoor space and a third switching pressure, which is predetermined, are obtained. In a case that the unit load pressure is higher than the third switching pressure, the indoor heat exchange system is activated, and both the first electronic control valve 6 and the second electronic control valves 11 are opened. In a case that the unit load pressure is lower than or equal to the third switching pressure, the indoor heat exchange system is shut down, the first electronic control valve 6 is opened, and the second electronic control valve 11 is closed. In a case that the refrigerant pressure is higher than the second switching pressure, the indoor heat exchange system is activated, the first electronically controlled valve 6 is closed, and the second electronically controlled valve 11 is opened.

The control method according to this embodiment further includes the following steps when performing the step of activating the indoor heat exchange system, opening the first electronic control valve 6, and opening the second electronic control valve 11.

The first electronic control valve 6 is kept at its maximum opening degree. PID regulation is performed on the second electronic control valve 11 based on a pressure of the second condenser 10 of the indoor heat exchange system. PID calculation is performed for the compressor 9 of the indoor heat exchange system based on a predetermined indoor temperature and an actual indoor temperature, and an operating frequency of the compressor 9 is regulated based on the PID values. In this way, an opening degree of the second electronic control valve 11 is regulated based on the pressure of the second condenser 10, thereby regulating the condensation pressure of the second condenser 10 in real time. Meanwhile, on the basis of ensuring the condensation pressure of the second condenser 10, the operating frequency of the compressor 9 is regulated according to the PID values calculated based on the predetermined indoor temperature and the actual indoor temperature, ensuring a high energy efficiency ratio of the indoor heat exchange system.

After the step of activating the indoor heat exchange system, closing the first electronic control valve 6, and opening the second electronic control valve 11, the control method further includes the following steps.

The unit load rate of the indoor space and the target load rate, which is predetermined, are obtained. In a case that the unit load rate is lower than or equal to the target load rate, the indoor heat exchange system is shut down, the first electronic control valve 6 is opened, and the second electronic control valve 11 is closed. That is, as the air-conditioning unit continuously operates in the compressor mode, the indoor temperature gradually decreases, causing the unit load rate to gradually decrease. When the unit load rate decreases to lower than or equal to the target load rate, the air-conditioning unit switches from the compressor mode to the heat pipe mode, thereby reducing the energy consumption for activating the compressor 9 and consequently reducing the power consumption of the data center while maintaining cooling efficiency.

Additionally, when the air-conditioning unit operates in the heat pipe mode or switches to the heat pipe mode from other modes, that is, when performing the step of shutting down the indoor heat exchange system and opening the first electronic control valve 6, this step also includes the following step.

PID calculation is performed based on the predetermined indoor temperature and the actual indoor temperature, and the opening degree of the first electronic control valve 6 is regulated according to PID values. This allows the opening degree of the first electronic control valve 6 to be controlled based on the indoor cooling demand, thereby meeting the indoor cooling demand.

It should be noted that the control method of the present application also includes the following steps.

A third switching pressure, which is predetermined, is obtained. The third switching pressure is lower than the second switching pressure. It is determined whether the refrigerant pressure is lower than the third switching pressure. In a case that the refrigerant pressure is lower than the third switching pressure, only the external fan corresponding to the first condenser 2 is activated. In a case that the refrigerant pressure is higher than or equal to the third switching pressure, it indicates that the heat exchange efficiency of the first condenser 2 is very poor, so both the external fan and the spray device need to be activated to improve the heat exchange efficiency of the first condenser 2 and ensure the heat exchange efficiency of the refrigerant in the outdoor heat exchange system.

Moreover, PID regulation is performed on a rotational speed of the outdoor fan or a spray volume of the spray device based on the refrigerant pressure, thereby automatically regulating the rotational speed of the outdoor fan and the spray volume of the spray device based on the outdoor temperature conditions to ensure the heat exchange efficiency of the outdoor heat exchange system.

In summary, based on the above embodiments, the composite air-conditioning unit according to the present application includes an outdoor heat exchange system and an indoor heat exchange system. Based on the different refrigerant pressures at the outlet of the first condenser 2 of the outdoor heat exchange system, the indoor heat exchange system is controlled to be activated or shut down, and each of the first electronic control valve 6 and the second electronic control valve 11 is controlled to be opened or closed, enabling the air-conditioning unit to operate in different cooling modes. The refrigerant pressure reflects the outdoor temperature conditions, with higher outdoor temperatures resulting in higher refrigerant pressures. This allows the air-conditioning unit to adjust its cooling mode based on different outdoor conditions and make full use of the outdoor natural cooling source in each cooling mode, and enabling the first condenser 2 of the outdoor heat exchange system to fully exchange heat with the outdoor natural cooling source. In this way, the refrigerant in the outdoor heat exchange system provides a cooling source for the indoor equipment room or the indoor heat exchange system to maximize the utilization of the outdoor natural cooling source.

Furthermore, in different cooling modes of the air-conditioning unit, PID regulation can be performed on the opening degree of the first electronic control valve 6 or the operating frequency of the compressor 9 of the indoor heat exchange system based on the predetermined indoor temperature and the actual indoor temperature, as well as on the opening degree of the second electronic control valve 11 based on the condensation pressure of the indoor heat exchange system. This allows precise control of the indoor air outlet temperature of the air-conditioning unit, ensuring its cooling efficiency.

It should be noted that, relational terms such as first and second are merely used to distinguish one entity from other entities, and do not require or imply that there are any such actual relationships or sequences among these entities herein.

The principle and the embodiments of the present application are described using specific embodiments. The above embodiments are described to facilitate understanding of the method and the core idea of the present application. Those skilled in the art may make several improvements and modifications to the present application without departing from the principles of the present application. These improvements and modifications shall fall within the protection scope of the claims of the present application.

## Claims

1. A composite air-conditioning unit, comprising:
an outdoor heat exchange system; and
an indoor heat exchange system, wherein
the outdoor heat exchange system comprises a main loop (1) for a refrigerant to flow through, a first condenser (2) and a pressure pump (4) are provided on the main loop (1), the first condenser (2) is configured to exchange heat with an external environment, and a plurality of branches (5) corresponding to the indoor heat exchange system are provided on the main loop (1);
the indoor heat exchange system comprises a compressor (9), a second condenser (10), a throttling element (12), and a second evaporator (8), which are connected to form a refrigerant circulation loop of the indoor heat exchange system, a number of the indoor heat exchange system is at least one, each indoor heat exchange system corresponds to at least two branches (5) of the plurality of branches (5);
one of the at least two branches (5) is provided with a first electronic control valve (6) and a first evaporator (7) that are connected in series, and another of the at least two branches (5) is provided with a second electronic control valve (11) and is configured to exchange heat with the second condenser (10) to remove heat from a refrigerant in the indoor heat exchange system; and
both the first evaporator (7) and the second evaporator (8) are located in an indoor space, at least one of the first evaporator (7) and the second evaporator (8) is configured to provide cooling capacity to the indoor space, and the first evaporator (7) and the second evaporator (8) are arranged in series in an airflow direction.

2. The composite air-conditioning unit according to claim 1, wherein
the first condenser (2) is an evaporative condenser, which comprises a heat exchange coil in communication with the main loop (1);
an external fan is provided at a side of the heat exchange coil;
the evaporative condenser further comprises a spray device configured to spray towards the heat exchange coil; and
a temperature sensor and/or a pressure sensor is provided at an outlet end of the heat exchange coil to detect a refrigerant temperature and/or a refrigerant pressure at an outlet of the evaporative condenser.

3. The composite air-conditioning unit according to claim 1, wherein the refrigerant in the outdoor heat exchange system and the refrigerant in the indoor heat exchange system are fluorinated refrigerants.

4. The composite air-conditioning unit according to claim 1, wherein the outdoor heat exchange system further comprises a liquid storage tank (3) provided on the main loop (1), a number of the pressure pump (4) is at least two, and the at least two pressure pumps (4) are connected in parallel and arranged at a liquid outlet end of the liquid storage tank (3).

5. The composite air-conditioning unit according to claim 1, wherein the second condenser (10) is a plate heat exchanger for heat exchange between fluorinated refrigerants.

6. A control method, applied to the composite air-conditioning unit according to any one of claims 1 to 5, comprising:
obtaining a first switching pressure and a second switching pressure that are predetermined, and obtaining a refrigerant pressure at an outlet of the first condenser (2) under a current outdoor temperature, wherein the second switching pressure is higher than the first switching pressure;
in a case that the refrigerant pressure is lower than the first switching pressure, shutting down the indoor heat exchange system, opening the first electronic control valve (6), and closing the second electronic control valve (11);
in a case that the refrigerant pressure is higher than or equal to the first switching pressure and lower than or equal to the second switching pressure, obtaining a unit load rate in the indoor space and a target load rate that is predetermined, wherein
in a case that the unit load rate is higher than the target load rate, activating the indoor heat exchange system, and opening the first electronic control valve (6) and the second electronic control valve (11); and
in a case that the unit load rate is lower than or equal to the target load rate, shutting down the indoor heat exchange system, opening the first electronic control valve (6), and closing the second electronic control valve (11); and
in a case that the refrigerant pressure is higher than the second switching pressure, activating the indoor heat exchange system, closing the first electronic control valve (6), and opening the second electronic control valve (11).

7. The control method according to claim 6, wherein the step of activating the indoor heat exchange system, and opening the first electronic control valve (6) and the second electronic control valve (11) comprises:
maintaining the first electronic control valve (6) at a maximum opening degree;
performing PID regulation on the second electronic control valve (11) based on a pressure of the second condenser (10) of the indoor heat exchange system; and
performing PID calculation for the compressor (9) of the indoor heat exchange system based on a predetermined indoor temperature and an actual indoor temperature, and regulating an operating frequency of the compressor (9) based on PID values.

8. The control method according to claim 6, wherein the step of activating the indoor heat exchange system, closing the first electronic control valve (6), and opening the second electronic control valve (11) comprises:
performing PID regulation on the second electronic control valve (11) based on a pressure of the second condenser (10) of the indoor heat exchange system; and
performing PID calculation for the compressor (9) of the indoor heat exchange system based on a predetermined indoor temperature and an actual indoor temperature, and regulating an operating frequency of the compressor (9) based on PID values.

9. The control method according to claim 6 or 8, after the step of activating the indoor heat exchange system, closing the first electronic control valve (6), and opening the second electronic control valve (11), comprising:
obtaining the unit load rate in the indoor space and the target load rate that is predetermined, wherein
in response to the unit load rate being lower than or equal to the target load rate, shutting down the indoor heat exchange system, opening the first electronic control valve (6), and closing the second electronic control valve (11).

10. The control method according to claim 9, wherein the step of shutting down the indoor heat exchange system and opening the first electronic control valve (6) comprises:
performing PID calculation based on the predetermined indoor temperature and the actual indoor temperature, and regulating an opening degree of the first electronic control valve (6) based on PID values.

11. The control method according to claim 6, comprising:
obtaining a third switching pressure that is predetermined, and determining whether the refrigerant pressure is lower than the third switching pressure, wherein the third switching pressure is lower than the second switching pressure, wherein
in a case that the refrigerant pressure is lower than the third switching pressure, activating only an external fan corresponding to the first condenser (2); and
in a case that the refrigerant pressure is higher than or equal to the third switching pressure, activating both the external fan and a spray device.

12. The control method according to claim 11, wherein PID regulation is performed on a rotational speed of the external fan or a spray water volume of the spray device based on the refrigerant pressure.
